(19) Europäisches Patentamt
European Patent Office
Office européen des brevets

(11) EP 3 425 021 B1

(12) EUROPEAN PATENT SPECIFICATION

(45) Date of publication and mention of the grant of the patent:
**08.07.2020 Bulletin 2020/28**

(21) Application number: **17759763.0**

(22) Date of filing: **22.02.2017**

(51) Int Cl.:
***C09K 11/08*** *(2006.01)* ***B82Y 30/00*** *(2011.01)*
***C01B 25/08*** *(2006.01)* ***C08K 9/04*** *(2006.01)*
***C08L 101/00*** *(2006.01)* ***C09D 17/00*** *(2006.01)*
***C09K 11/62*** *(2006.01)* ***C09K 11/70*** *(2006.01)*
***C09K 11/74*** *(2006.01)* ***H01L 21/208*** *(2006.01)*
***H01L 29/06*** *(2006.01)* ***C09K 11/56*** *(2006.01)*
***C09K 11/88*** *(2006.01)* ***B82Y 20/00*** *(2011.01)*
***B82Y 35/00*** *(2011.01)* ***H01L 51/50*** *(2006.01)*
***H01L 51/00*** *(2006.01)* ***H01L 31/055*** *(2014.01)*
***C09D 7/40*** *(2018.01)*

(86) International application number:
**PCT/JP2017/006567**

(87) International publication number:
**WO 2017/150297 (08.09.2017 Gazette 2017/36)**

(54) **SEMICONDUCTOR NANOPARTICLES, DISPERSION LIQUID, AND FILM**

HALBLEITERNANOPARTIKEL, DISPERSIONSFLÜSSIGKEIT UND FILM

NANOPARTICULES SEMI-CONDUCTRICES, DISPERSION LIQUIDE, ET FILM

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.02.2016 JP 2016037585**

(43) Date of publication of application:
**09.01.2019 Bulletin 2019/02**

(73) Proprietor: **FUJIFILM Corporation**
**Tokyo 106-8620 (JP)**

(72) Inventor: **SASAKI Tsutomu**
**Ashigara-kami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**CN-A- 102 879 364** **JP-A- 2012 532 953**
**JP-A- 2013 533 352** **KR-A- 20140 021 735**
**US-A1- 2012 001 217**

- **Sudarsan Tamang ET AL: "Synthesis and functionalisation of near infrared emitting nanocrystals for biological imaging", , 24 June 2011 (2011-06-24), XP055563945, Retrieved from the Internet: URL:https://www.researchgate.net/profile/Sudarsan_Tamang2/publication/278381450_Synthesis_and_functionalisation_of_near_infrared_emitting_nanocrystals_for_biological_imaging/links/58c8b8c0a6fdcca65708fae7/Synthesis-and-functionalisation-of-near-infrared-emitting-nanocrystals-for-biological-imaging.pdf [retrieved on 2019-03-04]**
- **SUDARSAN TAMANG ET AL: "Compact and highly stable quantum dots through optimized aqueous phase transfer", PROCEEDINGS OF SPIE, vol. 7909, 10 March 2011 (2011-03-10), pages 79091B-79091B-6, XP055563968, 1000 20th St. Bellingham WA 98225-6705 USA ISSN: 0277-786X, DOI: 10.1117/12.873805 ISBN: 978-1-5106-2099-5**
- **EDMOND GRAVEL ET AL: "Compact tridentate ligands for enhanced aqueous stability of quantum dots and in vivo imaging", CHEMICAL SCIENCE, vol. 4, no. 1, 1 January 2013 (2013-01-01) , pages 411-417, XP055415131, United Kingdom ISSN: 2041-6520, DOI: 10.1039/C2SC21113K**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 425 021 B1

- **GRAVEL, E. ET AL.: 'Compact tridentate ligands for enhanced aqueous stability of quantum dots and in vivo imaging' CHEMICAL SCIENCE vol. 4, no. 1, 2013, ISSN 2041-6520 pages 411 - 417, XP055415131**
- **VIRIEUX, H. ET AL.: 'InP/ZnS Nanocrystals: Coupling NMR and XPS for Fine Surface and Interface Description' JOURNAL OF THE AMERICAN CHEMICAL SOCIETY vol. 134, 2012, ISSN 0002-7863 pages 19701 - 19708, XP055330535**

## Description

### BACKGROUND OF THE INVENTION

1. Field of the Invention

The present invention relates to a semiconductor nanoparticle, a dispersion liquid, and a film.

2. Description of the Related Art

Single nano-sized colloidal semiconductor nanoparticles (hereinafter, also referred to as "quantum dots"), obtained by a chemical synthesis method in a solution containing a metal element, have been put into practical use as fluorescent materials in wavelength conversion films for some display applications. In addition, quantum dots are expected to be applied to, for example, biological labels, light emitting diodes, solar cells and thin film transistors.

After suggestion of a hot soap method (also referred to as a hot injection method), which is a method of chemical synthesis of quantum dots, the research of quantum dots has been actively carried out around the world.

For example, JP-A-2002-121549 discloses a semiconductor ultrafine particle obtained by bonding a polyalkylene glycol residue to a surface of a semiconductor crystal, and discloses an aspect in which the polyalkylene glycol residue is bonded to the surface of the semiconductor crystal through a ω-mercapto fatty acid residue.

Further, JP-B-4181435 discloses a water-soluble polyethylene glycol-modified semiconductor fine particle obtained by bonding a polyethylene glycol having a thiol group at least at one terminal and having a number-average molecular weight of 300-20000 to a Group II-VI semiconductor microcrystal having a core-shell structure having a ZnO, ZnS, ZnSe, or ZnTe shell through cadmium.

On the other hand, it has been reported in E. Gravel et al., Chem. Sci., 4, 411 (2013) that a ligand having a polyethylene glycol (hereinafter, also abbreviated as "PEG") chain and represented by TMM-PEG 2000 (1) shown below is introduced into a cadmium (Cd)-based quantum dot.

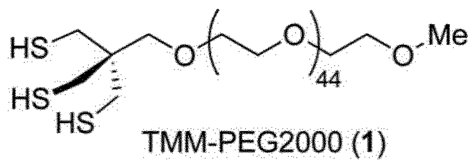

TMM-PEG2000 (**1**)

In addition, it has been reported in B.R. Liu et al., Colloids and Surfaces B: Biointerfaces, 111, 162 (2013) that 1,2-distearoyl-sn-glycero-3-phosphoethanolamine-N-(methoxy(polyethylene glycol)-2000) is coordinated to InP/ZnS using an intermolecular force with palmitic acid.

S. Tamang et al., Proceedings of SPIE, 7909, pp. 79091B-7909B-6 (2011) and S. Tamang, Ph.D. Thesis, University of Grenoble, FR, June 24, 2011 disclose InP/ZnS core shell nanoparticles covered with DHLA (dihydrolipoic acid; 6,8-Dimercaptooctanoic acid) as a ligand.

US-A-2012/001217 describes InP/ZnS/InZnS/ZnS core shell nanoparticles covered with a ligand which may be a mercapto-compound having two or more mercapto groups. Therein, the mercapto groups is present in form of two or more a carboxylic acid ester moieties of the formula $HS-(CH_2)_2-C(=O)-O-$.

KR-A-2014-0021735 discloses InP/ZnS or GaAs/ZnS core shell nanoparticles covered with a ligand which is a mercapto-compound of the formula $(HS-CH_2)_3C-C-O-(CH_2)_9-CH_3$.

### SUMMARY OF THE INVENTION

From the viewpoint of avoiding regulations such as Restriction on Hazardous Substances (Rohs), the present inventors have attempted to apply the ligands used for Cd-based quantum dots described in each of the foregoing documents (in particular, JP-B-4181435 and E. Gravel et al., Chem. Sci.,, 4, 411 (2013) to quantum dots of Group III elements such as indium (In)-based quantum dots and then found that, depending on the structure of the ligand, the luminous efficiency of the obtained semiconductor nanoparticles may be inferior in some cases, or the luminescence stability thereof against e.g. ultraviolet rays (hereinafter, also referred to as "durability") may be inferior in some cases.

Accordingly, an object of the present invention is to provide a semiconductor nanoparticle having an excellent durability, and a dispersion liquid and a film, each of which uses the semiconductor nanoparticle.

As a result of extensive studies to achieve the foregoing object, the present inventors have found that the durability of a semiconductor nanoparticle is improved in the case where a semiconductor nanoparticle obtained by

introducing a specific ligand is a semiconductor nanoparticle in which a predetermined element is detected by X-ray photoelectron spectroscopy and a predetermined peak is detected by Fourier transform infrared spectroscopy. The present invention has been completed based on these findings.

That is, it has been found that the foregoing object can be achieved by a semiconductor nanoparticle comprising a core containing a Group III element selected from any of In, Al and Ga, and a Group V element selected from any of P, N and As, wherein the nanoparticle

- contains carbon, oxygen, and sulfur, as detected by X-ray photoelectron spectroscopy,
- has peak A located at 2800-3000 $cm^{-1}$, peak B located at 1000-1200 $cm^{-1}$, and peak C located at 2450-2650 $cm^{-1}$, as detected by FT-IR spectroscopy, and
- contains a ligand having

(i) a structure I of any of formulae (Ia)-(Ic) wherein * is a bonding position and R is an aliphatic $C_{1-8}$-hydrocarbon group:

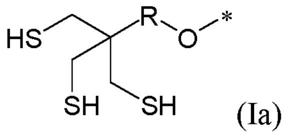 (Ia) 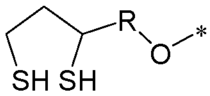 (Ib) 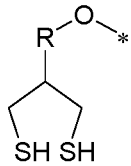 (Ic);

(ii) a structure II of formula (IIa) wherein * is a bonding position and *n* is integer of 1-5:

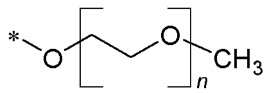 (IIa),

and

(iii) between structures I and II, a structure III represented by a linear aliphatic $C_{8-25}$-hydrocarbon group.

Also, the foregoing object can be achieved by a dispersion liquid or a film, comprising the semiconductor nanoparticle of the invention as defined above.

Preferred embodiments of the invention are as defined in the appended dependent claims and/or in the following detailed description.

According to the present invention, provided are a semiconductor nanoparticle having an excellent durability, and a dispersion liquid and a film, each of which uses the semiconductor nanoparticle.

## DESCRIPTION OF THE PREFERRED EMBODIMENTS

Hereinafter, the present invention will be described in detail.

In the present specification, a numerical range expressed using "to" means a range including numerical values described before and after "to" as a lower limit value and an upper limit value, respectively.

[Semiconductor nanoparticle]

The semiconductor nanoparticle of the present invention is a semiconductor nanoparticle comprising a core containing a Group III element selected from any of In, Al and Ga, and a Group V element selected from any of P, N and As, wherein the nanoparticle

- contains carbon, oxygen, and sulfur, as detected by X-ray photoelectron spectroscopy,
- has peak A located at 2800-3000 $cm^{-1}$, peak B located at 1000-1200 $cm^{-1}$, and peak C located at 2450-2650 $cm^{-1}$, as detected by FT-IR spectroscopy, and
- contains a ligand having

(i) a structure I of any of formulae (Ia)-(Ic) wherein * is a bonding position and R is an aliphatic $C_{1-8}$-hydrocarbon group:

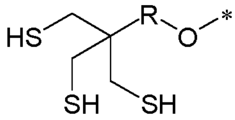 (Ia) 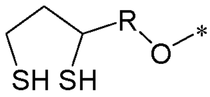 (Ib) 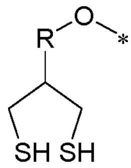 (Ic);

(ii) a structure II of formula (IIa) wherein * is a bonding position and *n* is integer of 1-5:

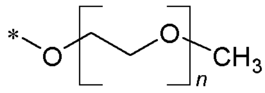 (IIa),

and

(iii) between structures I and II, a structure III represented by a linear aliphatic $C_{8-25}$-hydrocarbon group.

In the present invention, the detection of carbon, oxygen, and sulfur by XPS is determined based on whether or not carbon, oxygen, and sulfur are detected in the case of being measured under the following measurement conditions.

In addition, the peak intensity of an element detected by XPS is an area intensity obtained by subtracting the background from the peak observed under the following measurement conditions and integrating the area of the peak with respect to the energy.

In addition, the XPS measurement is carried out using a sample obtained by applying a dispersion liquid (solvent: toluene) containing semiconductor nanoparticles onto a non-doped Si substrate and then drying it.

<Measurement condition>

- Measuring device: XPS, Quantera SXM manufactured by Ulvac-PHI, Inc.
- X-ray source: Al-Kα rays (analysis diameter 100 μm, 25 W, 15 kV)
- Photoelectron take-off angle: 45°
- Measurement range: 300 μm×300 μm
- Correction: Charge correction by combined use of electron gun and low speed ion gun
- Measuring elements (measuring orbits): C(1s), N(1s), O(1s), Si(2p), P(2p), S(2p), Cl(2p), Zn(2p3/2), Ga(2p3/2), In(3d5/2)

In the present invention, the detection of peak A, peak B, and peak C by FT-IR is determined based on whether or not peak A, peak B, and peak C are detected in the case of being measured under the following measurement conditions.

Further, the peak intensity ratio between peak A and peak B or peak C refers to a ratio of maximum peak intensity of peak (Icoo) to maximum peak intensity of peak ($I_{CH3}$), obtained by subtracting the background from each peak observed under the following measurement conditions.

In the FT-IR measurement, a dispersion liquid containing semiconductor nanoparticles is added dropwise directly on a detection unit using diamond attenuated total reflection (ATR) and sufficiently dried, and then the measurement is carried out under the following conditions. Examples of solvents suitable for dispersibility of semiconductor nanoparticles are toluene, acetone and ethanol.

<Measurement conditions>

- Measuring device: Nicolet 4700 (manufactured by Thermofisher Scientific Inc.)
- Detector: DTGS KBr
- Light source: IR
- Measurement accessories: Diamond ATR (direct dropwise addition of solution)
- Beam splitter: KBr
- Measuring wave number: 400-4000 $cm^{-1}$
- Measurement interval: 1.928 $cm^{-1}$

- Scan count: 32
- Resolution: 4

In the present invention, as described above, in the case where the semiconductor nanoparticle contains carbon, oxygen, and sulfur as detected by XPS, exhibits peak A, peak B, and peak C as detected by FT-IR, and has a ligand containing two or more mercapto groups, the durability of the semiconductor nanoparticle is improved.

Although the reason that the durability is improved like this is not clear, it is presumed to be approximate as follows.

Here, it is considered that the peak A located at 2800-3000 $cm^{-1}$ is mainly a peak derived from a hydrocarbon group (C-H stretching) (hereinafter, the peak A is also referred to as "$I_{CH}$"). For example, it is considered that the peak A is a peak showing that a hydrocarbon group constituting Structure III to be described later is present.

In addition, it is considered that the peak B located at 1000-1200 $cm^{-1}$ is mainly a peak derived from C-O-C stretching that constitutes the PEG chain (hereinafter, the peak B is also referred to as "$I_{PEG}$"). For example, it is considered that the peak B is a peak showing that a hydrocarbon group constituting the PEG chain of Structure II to be described later is present.

In addition, it is considered that the peak C located at 2450-2650 $cm^{-1}$ is mainly a peak derived from a mercapto group (S-H stretching) (hereinafter, the peak C is also referred to as "$I_{SH}$"). For example, it is considered that the peak C is a peak showing that a mercapto group in Structure I to be described is present.

Therefore, it is considered that the reason that the durability is improved as above is because, in the present invention, the coordination force of the ligand containing two or more mercapto groups with respect to the surface of the semiconductor nanoparticle is improved, and as a result, desorption of the ligand hardly occurs, so that the occurrence of surface defects could be suppressed.

Since the semiconductor nanoparticle of the present invention has a high luminous efficiency (particularly, initial luminous efficiency), the peak intensity ratio ($I_{PEG}/I_{CH}$) between peak A ($I_{CH}$) and peak B ($I_{PEG}$) detected by FT-IR preferably satisfies Equation (1), more preferably satisfies Equation (1-1), and still more preferably satisfies Equation (1-2).

$$0<\text{peak B/peak A}<2.5\cdots(1)$$

$$0.1<\text{peak B/peak A}<2.0\cdots(1\text{-}1)$$

$$0.5<\text{peak B/peak A}<1.5\cdots(1\text{-}2)$$

From the viewpoint that the semiconductor nanoparticle of the present invention has a better durability, the peak intensity ratio ($I_{SH}/I_{CH}$) between peak A ($I_{CH}$) and peak C ($I_{SH}$) detected by FT-IR preferably satisfies the following Equation (2), more preferably satisfies Equation (2-1), and still more preferably satisfies Equation (2-2).

$$0<\text{peak C/peak A}<0.15\cdots(2)$$

$$0.01<\text{peak C/peak A}<0.10\cdots(2\text{-}1)$$

$$0.05<\text{peak C/peak A}<0.10\cdots(2\text{-}2)$$

[Ligand]

The semiconductor nanoparticle of the present invention has a ligand containing two or more mercapto groups, which ligand is a ligand having

(i) a structure I of any of formulae (Ia)-(Ic) wherein * is a bonding position and R is an aliphatic $C_{1\text{-}8}$-hydrocarbon group:

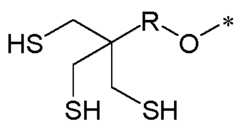 (Ia) 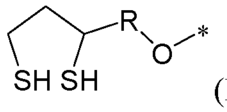 (Ib) 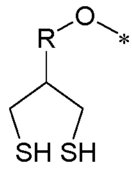 (Ic);

(ii) a structure II of formula (IIa) wherein * is a bonding position and *n* is integer of 1-5:

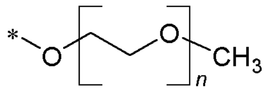 (IIa),

and

(iii) between structures I and II, a structure III represented by a linear aliphatic $C_{8-25}$-hydrocarbon group.

From the viewpoint of preventing the aggregation of the quantum dots, the ligand has a linear aliphatic $C_{8-25}$-hydrocarbon group.

Further, from the viewpoint of dispersibility in various solvents, the ligand has a PEG chain.

Further, from the viewpoint of durability, the ligand preferably has three mercapto groups.

In Formulae (Ia)-(Ic), R is an aliphatic $C_{1-8}$-hydrocarbon group, and is preferably an aliphatic $C_{1-6}$-hydrocarbon group.

Examples of the aliphatic $C_{1-8}$-hydrocarbon group include an alkylene group such as methylene, ethylene, propylene, isopropylene, butylene, pentylene or hexylene; an alkenylene group such as vinylene (-CH=CH-); an alkyne such as internal alkyne (-CH≡CH-); and a linking group formed by combining these groups.

In Formula (IIa), n is an integer of 1-5, and preferably an integer of 2-5.

The hydrocarbon group constituting Structure III is a linear aliphatic $C_{8-25}$-hydrocarbon group.

Here, examples of the linear aliphatic $C_{8-25}$-hydrocarbon group include alkylene groups such as octylene, nonylene, decylene, dodecylene and hexadecylene. The linear aliphatic hydrocarbon group may be, for example, a linking group formed by combining an alkylene group having ≤ 6 carbon atoms and vinylene (-CH=CH-), or a linking group formed by combining an alkylene group having ≤ 5 carbon atoms, vinylene (-CH=CH-), and an alkylene group having ≤ 5 or less carbon atoms, as long as it is a linear aliphatic hydrocarbon group having a total of 8-25 carbon atoms.

The ligand preferably has an average molecular weight of 300-1000 and more preferably 400-900.

Here, the average molecular weight is measured using matrix assisted laser desorption/ionization time of flight mass spectrometry (MALDI TOF MS).

From the viewpoints of initial characteristics, durability, aggregation prevention, and dispersibility, the ligand preferably is a compound of any of formulae (IVa), (IVb) and (IVc), and more preferably a compound of formula (IVa).

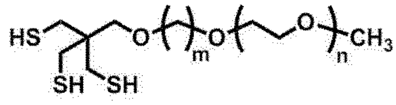 (IVa)

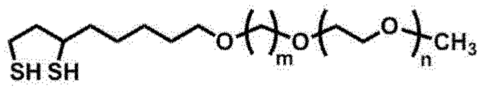 (IVb)

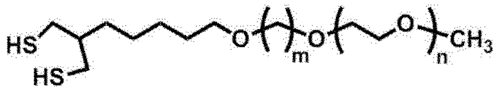 (IVc)

In formulae (IVa)-(IVc), m is an integer of 8-13, and n is an integer of 2-5.

The particle shape of the present semiconductor nanoparticle is not particularly limited, as long as the semiconductor nanoparticle has a core containing a Group III element selected from any of In, Al and Ga and a Group V element selected from any of P, N and As, and contains carbon, oxygen, and sulfur as detected by XPS, and has peak A ($I_{CH}$), peak B ($I_{PEG}$), and peak C ($I_{SH}$) as detected by FT-IR. For example, the particle shape of the present semiconductor nanoparticle is preferably a core shell shape such as a shape having a core containing a Group III element and a Group

V element and a shell containing a Group II element and a Group VI element covering at least a part of the surface of the core (single shell shape); or a shape having a core containing a Group III element and a Group V element, a first shell covering at least a part of the surface of the core, and a second shell covering at least a part of the first shell (multi-shell shape); among which a multi-shell shape is preferable.

[Core]

In the case where the present semiconductor nanoparticle is a core shell particle, the core of the core shell particle is a so-called Group III-V semiconductor containing a Group III element and a Group V element.

<Group III element>

The Group III element includes indium (In), aluminum (Al), and gallium (Ga), among which In is preferable.

<Group V element>

The Group V element includes phosphorus (P), nitrogen (N), and arsenic (As), among which P is preferable.

A Group III-V semiconductor obtained by appropriately combining the Group III element and the Group V element defined above can be used as the core, but InP, InN, or InAs is preferable from the viewpoint that the luminous efficiency is further increased, the luminous half-width is narrowed, and a clear exciton peak is obtained. Among them, InP is more preferable from the viewpoint of further increasing the luminous efficiency.

It is preferred that the core further contains a Group II element in addition to the Group III element and the Group V element described above. In particular, in the case where the core is InP, the lattice constant is decreased by doping Zn as the Group II element and therefore the lattice matching performance with a shell (for example, GaP or ZnS which will be described below) having a smaller lattice constant than that of InP becomes higher.

[Shell]

In the case where the present semiconductor nanoparticle is a single shell-shaped core shell particle, the shell is a material covering at least a part of the surface of the core and is preferably a so-called Group II-VI semiconductor containing a Group II element and a Group VI element.

Here, whether or not at least a part of the surface of the core is covered with the shell can also be confirmed based on the composition distribution analysis by, for example, transmission electron microscope (TEM)-energy dispersive X-ray spectroscopy (EDX).

<Group II element>

Specific examples of the Group II element include zinc (Zn), cadmium (Cd), and magnesium (Mg), among which Zn is preferable.

<Group VI element>

Specific examples of the Group VI element include sulfur (S), oxygen (O), selenium (Se), and tellurium (Te), among which S or Se is preferable, and S is more preferable.

A Group II-VI semiconductor obtained by appropriately combining the Group II element and the Group VI element described above can be used as the shell, but it is preferred that the shell is a crystal system which is the same as or similar to the core described above.

Specifically, ZnS or ZnSe is preferable and ZnS is more preferable.

[First shell]

In the case where the present semiconductor nanoparticle is a multi-shell shaped core shell particle, the first shell is a material covering at least a part of the surface of the core.

Here, whether or not at least a part of the surface of the core is covered with the first shell can also be confirmed based on the composition distribution analysis by, for example, transmission electron microscope-energy dispersive X-ray spectroscopy (TEM-EDX).

From the viewpoint of easily suppressing defects of the interface between the core and the first shell, it is preferred that the first shell contains a Group II element or a Group III element.

Here, in the case where the first shell contains a Group III element, the Group III element contained in the first shell is a Group III element different from the Group III element contained in the core described above.

Further, in addition to a Group II-VI semiconductor and a Group III-V semiconductor described below, a Group III-VI semiconductor (for example, $Ga_2O_3$ or $Ga_2S_3$) containing a Group III element and a Group VI element may be exemplified as the first shell containing a Group II element or a Group III element.

From the viewpoint of obtaining an excellent crystal phase with less defects, it is preferred that the first shell is a Group II-VI semiconductor containing a Group II element and a Group VI element or a Group III-V semiconductor containing a Group III element and a Group V element and it is more preferred that the first shell is a Group III-V semiconductor in which a difference in lattice constant between the core described above and the first shell is small.

Here, in the case where the first shell is a Group III-V semiconductor, the Group III element contained in the Group III-V semiconductor is a Group III element different from the Group III element contained in the core described above.

<Group II-VI semiconductor>

Specific examples of the Group II element contained in the Group II-VI semiconductor include zinc (Zn), cadmium (Cd), and magnesium (Mg), among which Zn is preferable.

Specific examples of the Group VI element contained in the Group II-VI semiconductor include sulfur (S), oxygen (O), selenium (Se), and tellurium (Te), among which S or Se is preferable, and S is more preferable.

A Group II-VI semiconductor obtained by appropriately combining the Group II element and the Group VI element described above can be used as the first shell, but it is preferred that the first shell is a crystal system (for example, a zinc blende structure) which is the same as or similar to the core described above. Specifically, ZnSe, ZnS, or a mixed crystal thereof is preferable and ZnSe is more preferable.

<Group III-V semiconductor

Specific examples of the Group III element contained in the Group III-V semiconductor include indium (In), aluminum (Al), and gallium (Ga), among which Ga is preferable. As described above, the Group III element contained in the Group III-V semiconductor is a Group III element different from the Group III element contained in the core described above. For example, in the case where the Group III element contained in the core is In, the Group III element contained in the Group III-V semiconductor is Al or Ga.

Specific examples of the Group V element contained in the Group III-V semiconductor include P (phosphorus), N (nitrogen), and As (arsenic), among which P is preferable.

A Group III-V semiconductor obtained by appropriately combining the Group III element and the Group V element described above can be used as the first shell, but it is preferred that the first shell is a crystal system (for example, a zinc blende structure) which is the same as or similar to the core described above. Specifically, GaP is preferable.

From the viewpoint of reducing defects of the surface of the core shell particle to be obtained, it is preferred that a difference in lattice constant between the core and the first shell is small. Specifically, it is preferred that the difference in lattice constant between the core and the first shell is $\leq 10\%$.

Specifically, in the case where the core is InP, as described above, it is preferred that the first shell is ZnSe (difference in lattice constant: 3.4%) or GaP (difference in lattice constant: 7.1%). Particularly, it is more preferred that the first shell is the same Group III-V semiconductor as the core and the Group III-V semiconductor is GaP from the viewpoint that a mixed crystal state can be easily made on the interface between the core and the first shell.

In the case where the first shell is a Group III-V semiconductor, the first shell may contain or dope another element (for example, the Group II element or the Group VI element described above) within the range that does not affect the magnitude correlation (core<first shell) of the band gap between the core and the first shell. Similarly, in the case where the first shell is a Group II-VI semiconductor, the first shell may contain or dope another element (for example, the Group III element or the Group V element described above) within the range that does not affect the magnitude correlation (core<first shell) of the band gap between the core and the first shell.

[Second shell]

In the case where the present semiconductor nanoparticle is a multi-shell shaped core shell particle, the second shell is a material covering at least a part of the surface of the first shell described above.

Here, whether or not at least a part of the surface of the first shell is covered with the second shell can also be confirmed based on the composition distribution analysis by, for example, transmission electron microscope-energy dispersive X-ray spectroscopy (TEM-EDX).

From the viewpoints of suppressing defects of the interface between the first shell and the second shell and obtaining an excellent crystal phase with less defects, it is preferred that the second shell is a Group II-VI semiconductor containing a Group II element and a Group VI element or a Group III-V semiconductor containing a Group III element and a Group V element. Further, from the viewpoints of high reactivity of the material itself and easily obtaining a shell with excellent crystallinity, it is more preferred that the second shell is a Group II-VI semiconductor.

Examples of the Group II element and the Group VI element, and the Group III element and the Group V element include those described in the section of the first shell.

A Group II-VI semiconductor obtained by appropriately combining the Group II element and the Group VI element described above can be used as the second shell, but it is preferred that the second shell is a crystal system (for example, a zinc blende structure) which is the same as or similar to the core described above. Specifically, ZnSe, ZnS, or a mixed crystal thereof is preferable and ZnS is more preferable.

A Group III-V semiconductor obtained by appropriately combining the Group III element and the Group V element described above can be used as the second shell, but it is preferred that the second shell is a crystal system (for example, a zinc blende structure) which is the same as or similar to the core described above. Specifically, GaP is preferable.

From the viewpoint of reducing defects of the surface of the core shell particle to be obtained, it is preferred that a difference in lattice constant between the first shell and the second shell is small. Specifically, it is preferred that the difference in lattice constant between the first shell and the second shell is $\leq$ 10%.

Specifically, in the case where the first shell is GaP, as described above, it is preferred that the second shell is ZnSe (difference in lattice constant: 3.8%) or ZnS (difference in lattice constant: 0.8%) and it is more preferred that the second shell is ZnS.

In the case where the second shell is a Group II-VI semiconductor, the second shell may contain or dope another element (for example, the Group III element or the Group V element described above) within the range that does not affect the magnitude correlation (core<second shell) of the band gap between the core and the second shell. Similarly, in the case where the second shell is a Group III-V semiconductor, the second shell may contain or dope another element (for example, the Group II element or the Group VI element described above) within the range that does not affect the magnitude correlation (core<second shell) of the band gap between the core and the second shell.

From the viewpoint that epitaxial growth becomes easy and defects of an interface between layers are easily suppressed, it is preferred that each of the core, the first shell, and the second shell described above is a crystal system having a zinc blende structure.

From the viewpoint that the probability of excitons staying in the core becomes higher and the luminous efficiency is further increased, it is preferred that the band gap of the core from among the core, the first shell, and the second shell described above is the smallest and the core and the first shell are core shell particles having a type 1 (type I) band structure.

[Average particle diameter]

From the viewpoints of easily synthesizing particles having a uniform size and easily controlling the emission wavelength using quantum size effects, the average particle diameter of the present semiconductor nanoparticles is preferably $\geq$ 2 nm and more preferably $\leq$ 10 nm.

Here, the average particle diameter refers to a value obtained by directly observing at least 20 particles using a transmission electron microscope, calculating the diameters of circles having the same area as the projected area of the particles, and arithmetically averaging these values.

[Method for producing core shell particles]

A method for producing the semiconductor nanoparticle of the present invention (hereinafter, also referred to as "present production method" in a formal sense) is a method for producing semiconductor nanoparticles, having a mixing step of mixing semiconductor nanoparticles QD having no ligand with a ligand having two or more mercapto groups (hereinafter, abbreviated as "ligand A").

Further, the present production method may have a leaving step of leaving (standing) after the mixing step. The coordination of the ligand A to the semiconductor nanoparticle QD may proceed in the mixing step or may proceed in the leaving step.

Here, the ligand A is the same as that described above for the present semiconductor nanoparticle.

Further, the semiconductor nanoparticle QD is a semiconductor nanoparticle known in the related art to which the ligand A is not coordinated, and is a semiconductor nanoparticle in which one or more peaks of peak A ($I_{CH}$), peak B ($I_{PEG}$), and peak C ($I_{SH}$) are not detected by FT-IR.

In the production method, from the viewpoint that the ligand exchange of the ligand A easily proceeds, it is

preferable to mix the semiconductor nanoparticles QD and the ligand A at 20-100°C, and more preferably at 50-85°C.

From the same viewpoint, in the case of including a leaving step, it is preferable to leave at 20-100°C, and more preferably at 50-85°C.

In the present production method, from the viewpoint of suppressing the generation of defects, it is preferable to mix the semiconductor nanoparticles QD and the ligand A under a light shield and/or under a nitrogen atmosphere, and more preferably under a light shield and under a nitrogen atmosphere.

From the same viewpoint, in the case of including a leaving step, it is preferable to leave under a light shield and/or under a nitrogen atmosphere, and more preferably under a light shield and under a nitrogen atmosphere.

In the present production method, from the viewpoint that the ligand exchange of the ligand A easily proceeds, it is preferable to carry out a mixing step of mixing the semiconductor nanoparticles QD and the ligand A for ≥ 8 hours, and more preferably for 12-48 hours.

From the same viewpoint, in the case of including a leaving step, it is preferably carried out the step for ≥ 8 hours and more preferably for 12-48 hours.

[Dispersion liquid]

The dispersion liquid of the present invention is a dispersion liquid containing the present semiconductor nanoparticles described above.

Here, the solvent constituting the dispersion medium of the dispersion liquid is preferably a nonpolar solvent.

Specific examples of the nonpolar solvent include an aromatic hydrocarbon such as toluene; a halogenated alkyl such as chloroform; an aliphatic saturated hydrocarbon such as hexane, octane, n-decane, n-dodecane, n-hexadecane, or n-octadecane; an aliphatic unsaturated hydrocarbon such as 1-undecene, 1-dodecene, 1-hexadecene, or 1-octadecene; and trioctylphosphine.

The content (concentration) of the present semiconductor nanoparticles in the present dispersion liquid is preferably 0.1-100 mol/L and more preferably 0.1-1 mol/L, with respect to the total mass of the present dispersion liquid.

[Film]

The film of the present invention is a film containing the present semiconductor nanoparticles described above.

Since the present film has a high luminous efficiency and a good durability, the film can be applied to, for example, a wavelength conversion film for a display, a photoelectron conversion (or wavelength conversion) film of a solar cell, a biological label and a thin film transistor. In particular, since the present film exhibits an excellent durability against ultraviolet rays, it is suitably applied to a down-conversion or down-shifting type wavelength conversion film which absorbs light in a region of shorter wavelengths than those of the absorption edge of quantum dots and emits light of longer wavelengths.

Further, the film material as a base material constituting the present film is not particularly limited and may be a resin or a thin glass film.

Specific examples thereof include resin materials mainly formed of an ionomer, polyethylene, polyvinyl chloride, polyvinylidene chloride, polyvinyl alcohol, polypropylene, polyester, polycarbonate, polystyrene, polyacrylonitrile, an ethylene vinyl acetate copolymer, an ethylene-vinyl alcohol copolymer, an ethylene-methacrylic acid copolymer film and nylon.

EXAMPLES

Hereinafter, the present invention will be described in more detail with reference to Examples.

<Synthesis of In-based semiconductor nanoparticles QD>

32 mL of octadecene, 140 mg (0.48 mmol) of indium acetate, and 48 mg (0.24 mmol) of zinc chloride were added to a flask, and the solution in the flask was heated and stirred at 110°C under vacuum to sufficiently dissolve the raw material while degassing for 90 minutes.

Next, the temperature of the flask was raised to 300°C under a nitrogen flow, and in the case where the temperature of the solution was stabilized, 0.24 mmol of tristrimethylsilylphosphine dissolved in about 4 mL of octadecene was added to the flask. Thereafter, the flask was heated for 120 minutes in a state in which the temperature of the solution was set to 230°C. It was confirmed that the color of the solution was red and particles (core) were formed.

Next, 30 mg (0.18 mmol) of gallium chloride and 125 μL (0.4 mmol) of oleic acid which were dissolved in 8 mL of octadecene were added to the solution in a state in which the solution was heated to 200°C, and the solution was further heated for approximately 1 hour, thereby obtaining a dispersion liquid of a core shell particle precursor including

InP (core) doped with Zn and GaP (first shell).

Next, the dispersion liquid was cooled to room temperature, 220 mg (1.2 mmol) of zinc acetate was added thereto, the dispersion liquid was heated to 230°C, and the temperature thereof was maintained for approximately 4 hours. Next, 1.15 mL (4.85 mmol) of dodecanethiol was added to the dispersion liquid which was then heated to 240°C. After cooling the resulting dispersion liquid to room temperature, 293 mg (1.6 mmol) of zinc acetate was added again, and the solution was heated to 230°C and kept for about 1 hour. Thereafter, 1.53 mL (6.5 mmol) of dodecanethiol was added again, and the dispersion liquid was heated to 240°C. After cooling the resulting dispersion liquid to room temperature, ethanol was added thereto, and centrifugation was carried out on the dispersion liquid so that particles were precipitated. The supernatant was discarded, and the resultant was dispersed in a toluene solvent.

In this manner, a toluene dispersion liquid of core shell particles (InP/GaP/ZnS) including InP (core) doped with Zn, GaP (first shell) covering the surface of the core, and ZnS (second shell) covering the surface of the first shell was obtained.

<Synthesis of Cd-based semiconductor nanoparticles QD>

Cd-based semiconductor nanoparticles were synthesized based on the reaction of the carboxylic acid precursor described in E. Gravel et al., Chem. Sci., 4, 411 (2013) and the SILAR protocol.

Specifically, 60 mg of CdO, 280 mg of octadecylphosphonic acid (ODPA), and 3 g of trioctylphosphine oxide (TOPO) were added to a 50 mL flask, and the mixture was heated to 150°C, followed by degassing under vacuum for 1 hour. Nitrogen was then flowed thereinto and the reaction mixture was heated to 320°C to form a clear colorless solution. Subsequently, 1.0 mL of trioctylphosphine (TOP) was added, and in the case where the temperature reached 380°C, an SE/TOP solution (60 mg of Se in 0.5 mL of TOP) was rapidly poured into the flask to synthesize CdSe core nanocrystals.

The shell growth reaction was carried out by filling a hexane solution containing 100 nanomoles of CdSe quantum dots in a mixture of 1-octadecene (ODE, 3 mL) and oleylamine (OAM, 3 mL).

The reaction solution was then degassed under vacuum at 120°C for 1 hour and 20 minutes to completely remove hexane, water, and oxygen in the reaction solution.

Thereafter, the reaction solution was heated to 310°C at a heating rate of 18°C/min under nitrogen flow and stirring. After the temperature reached 240°C, a desired amount of cadmium (II) oleic acid (Cd-oleic acid, diluted with 6 ml of ODE) and octanethiol (1.2 equivalents of Cd-oleic acid, diluted with 6 mL of ODE) was added dropwise and injected into the reaction solution at a rate of 3 mL/h using a syringe pump. After injection was completed, 1 mL of oleic acid was immediately injected and the solution was further annealed at 310°C for 60 minutes. The CdSe/CdS core/shell quantum dots thus obtained were precipitated by adding acetone to obtain CdSe/CdS particles.

Thereafter, the mixture was further heated to 210°C, and a Zn:S stock solution was added dropwise thereto. The Zn:S stock solution was prepared by mixing 0.4 ml of a 1M solution of $Zn(C_2H_5)_2$ in hexane, 0.1 mL of bis(trimethylsilyl)sulfide and 3 mL of TOP. After the growth of the ZnS shell was completed, the ZnS shell was overcoated with CdSe/CdS by cooling the reaction mixture to 90°C and leaving it at this temperature for 1 hour.

[Examples 1-5] (Examples 2 and 5 are not according to the claimed invention)

<Ligand exchange>

The concentration of the solution was adjusted such that the absorbance of the toluene dispersion liquid of the prepared core shell particles (InP/GaP/ZnS) was 0.2 at the excitation wavelength of 450 nm.

Next, while stirring the solution, ligands were added such that the molar ratio (core shell particle :ligand) of the core shell particles to each of the ligands A-1 to A-5 having the structure and molecular weight shown in Table 1 below becomes 1:600 as in Example 1, followed by sealing with nitrogen. In this state, the solution was kept at 65°C and left for 24 hours under a light shield to proceed the ligand exchange, whereby semiconductor nanoparticles were prepared.

The structural formulae of the ligands A-1 to A-5 used in Examples 15 are shown below.

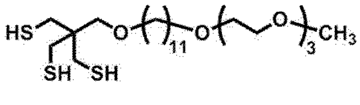

(A-1)

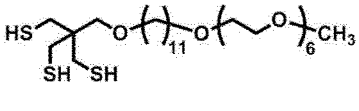

(A-2)

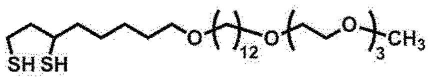

(A-3)

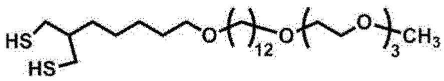

(A-4)

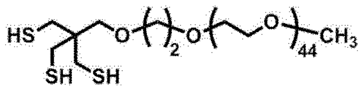

(A-5)

[Comparative Example 1]

Semiconductor nanoparticles were prepared in the same manner as in Example 5, except that Cd-based semiconductor nanoparticles QD were used in place of the core shell particles (InP/GaP/ZnS).

[Comparative Example 2]

According to the contents described in paragraph [0028] of JP4181435B, semiconductor nanoparticles having PEG introduced into CdSe-ZnS semiconductor microcrystals were prepared.

[Comparative Example 3]

Semiconductor nanoparticles were prepared in the same manner as in Comparative Example 2, except that the prepared core shell particles (InP/GaP/ZnS) were used in place of the CdSe-ZnS semiconductor microcrystals.

[Comparative Example 4]

Semiconductor nanoparticles having PEG introduced into CdSe/ZnS nanocrystals were prepared according to the contents described in paragraph [0070] of JP2002-121549A.

[Comparative Example 5]

Semiconductor nanoparticles were prepared in the same manner as in Comparative Example 4, except that the prepared core shell particles (InP/GaP/ZnS) were used in place of the CdSe/ZnS nanocrystals.

[XPS]

With respect to dispersion liquids containing the prepared respective semiconductor nanoparticles, the presence or absence of the detection of carbon (C), oxygen (O), and sulfur (S) was measured by XPS according to the above-mentioned method. The results are shown in Table 1 below.

[FT-IR]

Each of dispersion liquids (the solvent is selected from e.g. toluene, acetone and ethanol) containing the respective semiconductor nanoparticles of Examples 1-5 and Comparative Example 1 adjusted to have an optical density (O.D.) at 450 nm of 0.05-0.1 was added dropwise into a diamond ATR type detection unit, and according to the above-mentioned method, the presence or absence of detection of peak A ($I_{CH}$), peak B ($I_{PEG}$), and peak C ($I_{SH}$) by FT-IR, and the peak intensity ratio B/A ($I_{PEG}/I_{CH}$) and the peak intensity ratio C/A ($I_{SH}/I_{CH}$) were measured. The results are shown in Table 1 below.

[Luminous efficiency]

<Initial>

The concentration of each of dispersion liquids containing the prepared respective semiconductor nanoparticles was adjusted such that the absorbance at an excitation wavelength of 450 nm was 0.2, and the luminescence intensity

of the dispersion liquid was measured using a fluorescence spectrophotometer FluoroMax-3 (manufactured by Horiba Jobin Yvon SAS). The initial luminous efficiency was calculated by the comparison with a quantum dot sample whose luminous efficiency was known. The obtained luminous efficiency was calculated as a ratio of the number of emitted photons to the number of absorbed photons from excitation light. The results evaluated according to the following standards are shown in Table 1 below.

A: Initial luminous efficiency is ≥ 70%
B: Initial luminous efficiency is ≥ 65% and < 70%
C: Initial luminous efficiency is ≥ 60% and < 65%
D: Initial luminous efficiency is < 60%

<Durability: after UV irradiation>

Each of dispersion liquids containing the prepared respective semiconductor nanoparticles was fixed at a position of receiving 1 $mW/cm^2$ and irradiated with ultraviolet rays using a mercury lamp (wavelength: 365 nm). The irradiation amount of ultraviolet rays was 8 $J/cm^2$.

Thereafter, the luminous efficiency was measured in the same manner as in the initial luminous efficiency and evaluated according to the following standards for reduction from the initial luminous efficiency. The results are shown in Table 1 below.

a: Reduction from initial luminous efficiency is < 5%
b: Reduction from initial luminous efficiency is ≥ 5% and < 10%
c: Reduction from initial luminous efficiency is ≥ 10% and < 15%
d: Reduction from initial luminous efficiency is ≥ 15%

<Durability: in the case of being diluted>

Toluene was added to dilute each of dispersion liquids containing the prepared respective semiconductor nanoparticles such that an optical density (O.D.) at 450 nm was 0.03, and then dispersion liquids were left in the atmosphere for 10 hours.

Thereafter, the luminous efficiency was measured in the same manner as in the initial luminous efficiency and evaluated according to the following standards for reduction from the initial luminous efficiency. The results are shown in Table 1 below.

a: Reduction from initial luminous efficiency is < 5%
b: Reduction from initial luminous efficiency is ≥ 5% and < 10%
c: Reduction from initial luminous efficiency is ≥ 10% and < 15%
d: Reduction from initial luminous efficiency is ≥ 15%

[Table 1]

| | Core composition | Ligand | | | | | XPS | FT-IR | | | | | Evaluation | | |
|---|---|---|---|---|---|---|---|---|---|---|---|---|---|---|---|
| | | Type | Structure I | Structure II | Structure III | Molecular weight | Detection elements | Peak | | | Peak intensity ratio B/A | Peak intensity ratio C/A | Initial | Durability | |
| | | | Mercapto group (numbers) | PEG chain (n number) | Hydrocarbon group (m number) | | | A $I_{CH}$ | B $I_{PEG}$ | C $I_{SH}$ | | | | After irradiation of ultraviolet rays | In the case of being diluted |
| Example 1 | In-based | A-1 | 3 | 3 | 11 | 831 | C, O, S | Present | Present | Present | 1.0 | 0.06 | A | a | a |
| Example 2* | In-based | A-2 | 3 | 6 | 11 | 950 | C, O, S | Present | Present | Present | 1.5 | 0.06 | B | a | a |
| Example 3 | In-based | A-3 | 2 | 3 | 12 | 813 | C, O, S | Present | Present | Present | 0.8 | 0.04 | A | b | b |
| Example 4 | In-based | A-4 | 2 | 3 | 12 | 813 | C, O, S | Present | Present | Present | 0.8 | 0.04 | A | b | b |
| Example 5* | In-based | A-5 | 3 | 44 | 2 | 7700 | C, O, S | Present | Present | Present | 8.0 | 0.20 | D | a | a |
| Comparative Example 1 | Cd-based | A-5 | 3 | 44 | 2 | 7700 | C, O, S | Present | Present | Present | 8.0 | 0.20 | A | a | a |
| Comparative Example 2 | Cd-based | JP4181435B (mercapto group: one) | | | | | C, O, S | - | - | - | - | - | A | d | d |
| Comparative Example 3 | In-based | | | | | | C , O, S | - | - | - | - | - | D | d | d |
| Comparative Example 4 | Cd-based | JP2002-121549A (mercapto group: one) | | | | | C, O, S | - | - | - | - | - | B | d | d |
| Comparative Example 5 | In-based | | | | | | C , O, S | - | - | - | - | - | C | d | d |

*: not according to the claimed invention

From the results shown in Table 1, it was found that, in the case where carbon, oxygen, and sulfur were detected by XPS, peak A, peak B, and peak C were detected by FT-IR, and a ligand containing two or more mercapto groups was present, the semiconductor nanoparticles having an excellent durability comparable to Comparative Example 1 using Cd-based semiconductor nanoparticles were obtained (Examples 1-5).

Further, from the comparison between Examples 1-4 and Example 5 (not included in the claimed invention), it was found that the initial luminous efficiency was improved in the case where the peak intensity ratio ($I_{PEG}/I_{CH}$) between peak A ($I_{CH}$) and peak B ($I_{PEG}$) detected by FT-IR was > 0 and < 2.5.

Further, from the comparison between Example 1 and Examples 3 and 4, it was found that the durability was further improved in the case where the peak intensity ratio ($I_{SH}/I_{CH}$) between peak A ($I_{CH}$) and peak C ($I_{SH}$) detected by FT-IR was > 0.05 and < 0.10.

Further, from the comparison between Example 1 and Example 2 (not included in the claimed invention), it was found that the initial luminous efficiency was improved in the case where n in Formula (IIa) representing Structure II was an integer of 1-5.

On the other hand, it was found that since the ligand prepared by the method described in JP-A-2002-121549 and JP-B-4181435 has only one mercapto group in the ligand, the durability was inferior even in the case of being applied to In-based semiconductor nanoparticles.

## Claims

1. A semiconductor nanoparticle comprising a core containing a Group III element selected from any of In, Al and Ga, and a Group V element selected from any of P, N and As, wherein the nanoparticle

    - contains carbon, oxygen, and sulfur, as detected by X-ray photoelectron spectroscopy,
    - has peak A located at 2800-3000 $cm^{-1}$, peak B located at 1000-1200 $cm^{-1}$, and peak C located at 2450-2650 $cm^{-1}$, as detected by FT-IR spectroscopy, and
    - contains a ligand having

        (i) a structure I of any of formulae (Ia)-(Ic) wherein * is a bonding position and R is an aliphatic $C_{1-8}$-hydrocarbon group:

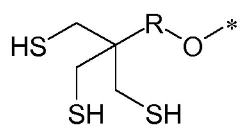 (Ia) 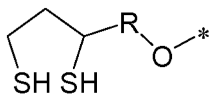 (Ib) 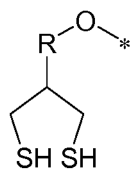 (Ic);

        (ii) a structure II of formula (IIa) wherein * is a bonding position and n is integer of 1-5:

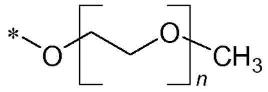 (IIa),

        and
        (iii) between structures I and II, a structure III represented by a linear aliphatic $C_{8-25}$-hydrocarbon group.

2. The semiconductor nanoparticle of claim 1, wherein the peak intensity ratio (B)/(A) between peaks B and A satisfies the relationship (1) of 0 < (B)/(A) < 2.5.

3. The semiconductor nanoparticle of claim 1 or 2, wherein the peak intensity ratio (C)/(A) between peaks C and A satisfies the relationship (2) of 0 < (C)/(A) < 0.15.

4. The semiconductor nanoparticle of any of claims 1-3, wherein the ligand has an average molecular weight of 300-1000.

5. The semiconductor nanoparticle of any of claims 1-4, wherein the ligand is a compound of any of formulae (IVa)-(IVc),

wherein m is an integer of 8-13 and n is an integer of 2-5:

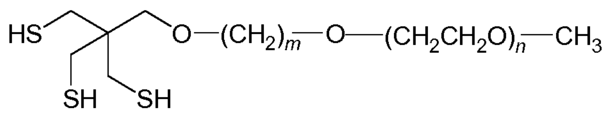

(IVa)

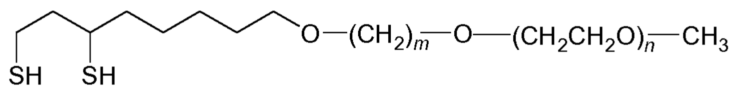

(IVb)

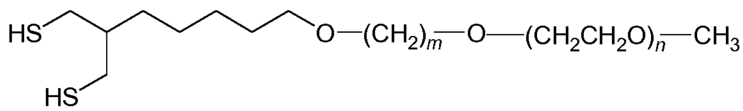

(IVc)

6. The semiconductor nanoparticle of any of claims 1-5, which has a shell containing a Group II element and a Group VI element and covering at least a part of the surface of the core.

7. The semiconductor nanoparticle of any of claims 1-5, which has a first shell covering at least a part of the surface of the core, and a second shell covering at least a part of the first shell.

8. The semiconductor nanoparticle of claim 6 or 7, wherein

- the Group III element contained in the core is In, and
- the Group V element contained in the core is any one of P, N, and As, and preferably is P.

9. The semiconductor nanoparticle of any of claims 6-8, wherein the core further contains a Group II element, and preferably Zn.

10. The semiconductor nanoparticle of any of claims 7-9, wherein the first shell contains a Group II element or a Group III element different from that contained in the core.

11. The semiconductor nanoparticle of claim 10, wherein the first shell is

- a Group II-VI semiconductor containing a Group II element and a Group VI element, preferably a Group II-VI semiconductor, wherein the Group II element is Zn and the Group VI element is Se or S; or
- a Group III-V semiconductor containing a Group III element different from that contained in the core and a Group V element, preferably a Group III-V semiconductor wherein the Group III element is Ga and the Group V element is P..

12. The semiconductor nanoparticle of any of claims 7-11, wherein the second shell is

- a Group II-VI semiconductor containing a Group II element and a Group VI element, preferably a Group II-VI semiconductor wherein the Group II element is Zn and the Group VI element is S, or
- a Group III-V semiconductor containing a Group III element and a Group V element.

13. The semiconductor nanoparticle of any of claims 7-12, wherein the core, the first shell, and the second shell are all crystal systems having a zinc blende structure.

14. The semiconductor nanoparticle of any of claims 7-13, wherein, among the core, the first shell, and the second shell, the core has the smallest band gap, and the core and the first shell exhibit a type 1 band structure.

15. A dispersion liquid or a film, comprising the semiconductor nanoparticle of any of claims 1-14.

**Patentansprüche**

1. Halbleiter-Nanopartikel, umfassend einen Kern, enthaltend ein Element der Gruppe III, ausgewählt aus irgendeinem von In, Al und Ga, und ein Element der Gruppe V, ausgewählt aus irgendeinem von P, N und As, worin der Nanopartikel

   - Kohlenstoff, Sauerstoff und Schwefel enthält, detektiert durch Röntgen-Fotoelektronenspektroskopie,
   - einen Peak A bei 2.800 bis 3.000 $cm^{-1}$, einen Peak B bei 1.000 bis 1.200 $cm^{-1}$ und einen Peak C bei 2.450 bis 2.650 $cm^{-1}$ aufweist, detektiert mittels FT-IR-Spektroskopie, und
   - einen Liganden enthält, aufweisend

     (i) eine Struktur I gemäß irgendeiner der Formeln (Ia) bis (Ic), worin * eine Bindungsposition ist und R eine aliphatische $C_{1-8}$-Kohlenwasserstoffgruppe ist:

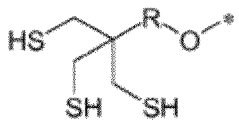 (Ia) 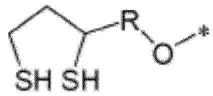 (Ib) 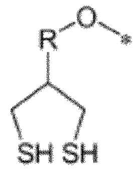 (Ic)

     (ii) eine Struktur II der Formel (IIa), worin * eine Bindungsposition ist und n eine ganze Zahl von 1 bis 5 ist:

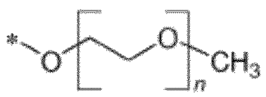 (IIa)

     und
     (iii) zwischen den Strukturen I und II, eine Struktur III, dargestellt durch eine lineare aliphatische $C_{8-25}$-Kohlenwasserstoffgruppe.

2. Halbleiter-Nanopartikel gemäß Anspruch 1, worin das Peakintensitätsverhältnis (B)/(A) zwischen den Peaks B und A die Beziehung (1) $0 < (B)/(A) < 2{,}5$ erfüllt.

3. Halbleiter-Nanopartikel gemäß Anspruch 1 oder 2, worin das Peakintensitätsverhältnis (C)/(A) zwischen den Peaks C und A die Beziehung (2) $0 < (C)/(A) < 0{,}15$ erfüllt.

4. Halbleiter-Nanopartikel gemäß irgendeinem der Ansprüche 1 bis 3, worin der Ligand ein mittleres Molekulargewicht von 300 bis 1.000 aufweist.

5. Halbleiter-Nanopartikel gemäß irgendeinem der Ansprüche 1 bis 4, worin der Ligand eine Verbindung gemäß irgendeiner der Formeln (Iva) bis (IVc) ist, worin m eine ganze Zahl von 8 bis 13 ist und n eine ganze Zahl von 2 bis 5 ist:

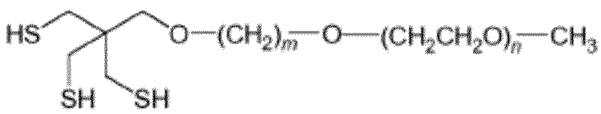 (IVa)

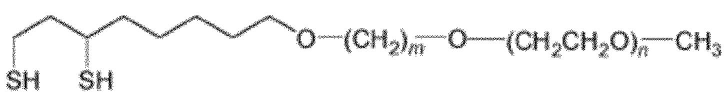 (IVb)

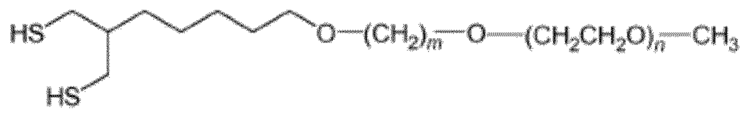

(IVc)

.

6. Halbleiter-Nanopartikel gemäß irgendeinem der Ansprüche 1 bis 5, der eine Schale aufweist, die ein Element der Gruppe II und ein Element der Gruppe VI enthält und zumindest einen Teil der Oberfläche des Kerns bedeckt.

7. Halbleiter-Nanopartikel gemäß irgendeinem der Ansprüche 1 bis 5, der eine erste Schale, die zumindest einen Teil der Oberfläche des Kerns bedeckt, und eine zweite Schale, die zumindest einen Teil der ersten Schale bedeckt, aufweist.

8. Halbleiter-Nanopartikel gemäß Anspruch 6 oder 7, worin

- das in dem Kern enthaltene Element der Gruppe III In ist und
- das in dem Kern enthaltene Element der Gruppe V irgendeines von P, N und As ist, und bevorzugt P ist.

9. Halbleiter-Nanopartikel gemäß irgendeinem der Ansprüche 6 bis 8, worin der Kern ferner ein Element der Gruppe II enthält und bevorzugt Zn enthält.

10. Halbleiter-Nanopartikel gemäß irgendeinem der Ansprüche 7 bis 9, worin die erste Schale ein Element der Gruppe II oder ein Element der Gruppe III enthält, das von dem in dem Kern Enthaltenen verschieden ist.

11. Halbleiter-Nanopartikel gemäß Anspruch 10, worin die erste Schale

- ein Gruppe II-VI-Halbleiter, enthaltend ein Element der Gruppe II und ein Element der Gruppe VI, bevorzugt ein Gruppe II-VI-Halbleiter, worin das Element der Gruppe II Zn ist und das Element der Gruppe VI Se oder S ist; oder
- ein Gruppe III-V-Halbleiter, enthaltend ein Element der Gruppe III, das sich von demjenigen unterscheidet, das im Kern enthalten ist, und ein Element der Gruppe V, bevorzugt ein Gruppe III-V-Halbleiter, worin das Element der Gruppe III Ga ist und das Element der Gruppe V P ist,

ist.

12. Halbleiter-Nanopartikel gemäß irgendeinem der Ansprüche 7 bis 11, worin die zweite Schale

- ein Gruppe II-VI-halbleiter, enthaltend ein Element der Gruppe II und ein Element der Gruppe VI, bevorzugt ein Gruppe II-VI-Halbleiter, worin das Element der Gruppe II Zn ist und das Element der Gruppe VI S ist; oder
- ein Gruppe III-V-Halbleiter, enthaltend ein Element der Gruppe III und ein Element der Gruppe V,

ist.

13. Halbleiter-Nanopartikel gemäß irgendeinem der Ansprüche 7 bis 12, worin der Kern, die erste Schale und die zweite Schale alle Kristallsysteme sind, die eine Zinkblendestruktur aufweisen.

14. Halbleiter-Nanopartikel gemäß irgendeinem der Ansprüche 7 bis 13, worin von dem Kern, der ersten Schale und der zweiten Schale der Kern die kleinste Bandlücke aufweist und der Kern und die erste Schale eine Bandstruktur vom Typ 1 aufweisen.

15. Dispersionsflüssigkeit oder Film, umfassend den Halbleiter-Nanopartikel gemäß irgendeinem der Ansprüche 1 bis 14.

## Revendications

1. Nanoparticule semi-conductrice comprenant un noyau contenant un élément du groupe III sélectionné parmi l'un de In, Al et Ga, et un élément du groupe V sélectionné parmi l'un de P, N et As, dans laquelle la nanoparticule

- contient du carbone, de l'oxygène et du soufre, détectés par spectroscopie photoélectronique aux rayons X,

- a un pic A situé entre 2800 et 3000 $cm^{-1}$, un pic B situé entre 1000 et 1200 $cm^{-1}$ et un pic C situé entre 2450 et 2650 $cm^{-1}$, tels que détectés par spectroscopie FT-IR, et
- contient un ligand ayant

(i) une structure I de l'une quelconque des formules (Ia) à (Ic) dans laquelle * est une position de liaison et R est un groupe hydrocarboné en $C_{1-8}$ aliphatique :

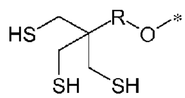 (Ia) 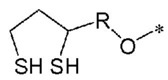 (Ib) 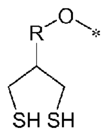 (Ic);

(ii) une structure II de formule (IIa) dans laquelle * est une position de liaison et *n* est un entier de 1-5 :

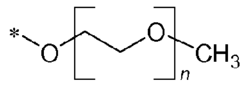 (IIa),

et
(iii) entre les structures I et II, une structure III représentée par un groupe hydrocarboné en $C_{8-25}$ aliphatique linéaire.

**2.** Nanoparticule semi-conductrice selon la revendication 1, dans laquelle le rapport d'intensité de pic (B)/(A) entre les pics B et A satisfait la relation (1) de $0 < (B)/(A) < 2,5$.

**3.** Nanoparticule semi-conductrice selon la revendication 1 ou 2, dans laquelle le rapport d'intensité de pic (C)/(A) entre les pics C et A satisfait la relation (2) de $0 < (C)/(A) < 0,15$.

**4.** Nanoparticule semi-conductrice selon l'une quelconque des revendications 1 à 3, dans laquelle le ligand a un poids moléculaire moyen de 300 à 1000.

**5.** Nanoparticule semi-conductrice selon l'une quelconque des revendications 1 à 4, dans laquelle le ligand est un composé de l'une quelconque des formules (IVa) à (IVc), dans laquelle m est un entier de 8 à 13 et *n* est un entier de 2 à 5 :

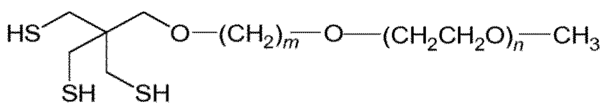
(IVa)

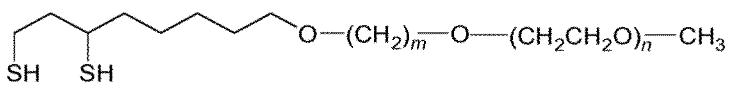
(IVb)

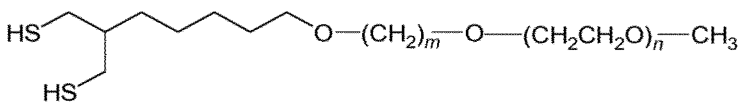
(IVc)

**6.** Nanoparticule semi-conductrice selon l'une quelconque des revendications 1 à 5, qui a une enveloppe contenant un élément du groupe II et un élément du groupe VI et recouvrant au moins une partie de la surface du noyau.

**7.** Nanoparticule semi-conductrice selon l'une quelconque des revendications 1 à 5, qui a une première enveloppe recouvrant au moins une partie de la surface du noyau, et une seconde enveloppe recouvrant au moins une partie de la première enveloppe.

**8.** Nanoparticule semi-conductrice selon la revendication 6 ou 7, dans laquelle

- l'élément du groupe III contenu dans le noyau est In, et
- l'élément du groupe V contenu dans le noyau est l'un quelconque de P, N et As, et de préférence est P.

**9.** Nanoparticule semi-conductrice selon l'une quelconque des revendications 6 à 8, dans laquelle le noyau contient en outre un élément du groupe II, et de préférence Zn.

**10.** Nanoparticule semi-conductrice selon l'une quelconque des revendications 7 à 9, dans laquelle la première enveloppe contient un élément du groupe II ou un élément du groupe III différent de celui contenu dans le noyau.

**11.** Nanoparticule semi-conductrice selon la revendication 10, dans laquelle la première enveloppe est

- un semi-conducteur du groupe II-VI contenant un élément du groupe II et un élément du groupe VI, de préférence un semi-conducteur du groupe II-VI, où l'élément du groupe II est Zn et l'élément du groupe VI est Se ou S ; ou
- un semi-conducteur du groupe III-V contenant un élément du groupe III différent de celui contenu dans le noyau et un élément du groupe V, de préférence un semi-conducteur du groupe III-V où l'élément du groupe III est Ga et l'élément du groupe V est P.

**12.** Nanoparticule semi-conductrice selon l'une quelconque des revendications 7 à 11, dans laquelle la seconde enveloppe est

- un semi-conducteur du groupe II-VI contenant un élément du groupe II et un élément du groupe VI, de préférence un semi-conducteur du groupe II-VI où l'élément du groupe II est Zn et l'élément du groupe VI est S, ou
- un semi-conducteur du groupe III-V contenant un élément du groupe III et un élément du groupe V.

**13.** Nanoparticule semi-conductrice selon l'une quelconque des revendications 7 à 12, dans laquelle le noyau, la première enveloppe et la seconde enveloppe sont tous des systèmes cristallins ayant une structure de sphalérite.

**14.** Nanoparticule semi-conductrice selon l'une quelconque des revendications 7 à 13, dans laquelle, parmi le noyau, la première enveloppe et la seconde enveloppe, le noyau a la plus petite bande interdite, et le noyau et la première enveloppe présentent une structure de bande de type 1.

**15.** Liquide de dispersion ou film, comprenant la nanoparticule semi-conductrice selon l'une quelconque des revendications 1 à 14.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002121549 A
- JP 4181435 B
- US 2012001217 A
- KR 20140021735 A


### Non-patent literature cited in the description


- **E. GRAVEL et al.** *Chem. Sci.,* 2013, vol. 4, 411
- **B.R. LIU et al.** *Colloids and Surfaces B: Biointerfaces,* 2013, vol. 111, 162
- **S. TAMANG et al.** *Proceedings of SPIE,* 2011, vol. 7909, 79091B-7909B, 6
- **S. TAMANG.** Ph.D. Thesis. University of Grenoble, 24 June 2011